# EUROPÄISCHE PATENTSCHRIFT

(11) **EP 3 207 198 B1**
(45) Veröffentlichungstag und Bekanntmachung des Hinweises auf die Patenterteilung: **09.11.2022**
(21) Anmeldenummer: 15770438.8
(22) Anmeldetag: 20.08.2015
(51) Int. Cl.: E05B 17/10, E05B 85/10, B60L 1/14, B60L 58/10, E05B 81/70, G01R 31/371

(54) **BETÄTIGUNGSHANDHABE FÜR EIN KRAFTFAHRZEUG**
ACTUATING HANDLE FOR A MOTOR VEHICLE
POIGNÉE D'ACTIONNEMENT POUR UN VÉHICULE AUTOMOBILE

(30) Priorität: 13.10.2014 DE 102014114799
(43) Veröffentlichungstag der Anmeldung: 23.08.2017
(73) Patentinhaber: Huf Hülsbeck & Fürst GmbH & Co. KG, 42551 Velbert (DE)
(72) Erfinder: BARTELS, Markus, 45472 Mülheim (DE); DIEKER, Coen, 7091 VW Dinxperlo (NL); MÜLLER, Dirk, 45359 Essen (DE); MÖNIG, Stefan, 58332 Schwelm (DE)
(86) Internationale Anmeldenummer: PCT/DE2015/100348
(87) Internationale Veröffentlichungsnummer: WO 2016/058584

(56) Entgegenhaltungen:
- EP-A1- 1 790 528
- WO-A1-2014/049026
- WO-A2-2010/130743
- DE-A1-102008 014 515
- DE-A1-102008 023 407
- DE-A1-102008 042 330
- DE-A1-102010 016 522
- US-A1- 2004 104 815
- US-A1- 2011 148 575

## Beschreibung

Die vorliegende Erfindung betrifft eine Betätigungshandhabe für ein Kraftfahrzeug zum Öffnen und/ oder Schließen von einer Türe oder einer Klappe gemäß dem Oberbegriff des Anspruches 1, wobei die Betätigungshandhabe ein Griffelement aufweist, welches zwischen einer Betätigungsposition, in welcher das Griffelement zum manuellen Öffnen einer Türe oder einer Klappe betätigbar angeordnet ist, und einer Verriegelungsposition, in welcher das Griffelement in einer Mulde aufgenommen ist, bewegbar ausgebildet ist, wobei das Griffelement umgebende Griffelementbegrenzungsabschnitte und die Mulde Muldenbegrenzungsabschnitte aufweist, wobei die Betätigungshandhabe derart ausgebildet ist, dass jeder der Griffelementbegrenzungsabschnitte in der Verriegelungsposition des Griffelements einem jeweils korrespondierenden Muldenbegrenzungsabschnitt gegenüberliegend angeordnet ist.

Betätigungshandhaben mit eingesetzten Leuchtmitteln sind beispielsweise aus den Dokumenten WO2014/049026 A1 und US2011/148575 A1 bekannt.

Bei bekannten Vorrichtungen für Kraftfahrzeuge zum Öffnen und/ oder Schließen von einer Türe oder einer Klappe wird ein Vorfeld bzw. ein vor der Türe oder der Klappe liegender Bereich nur ungenügend beleuchtet. Des Weiteren kann es vorkommen, dass die zur Beleuchtung eingesetzten Leuchtmittel verschmutzt werden und sich die Qualität der Beleuchtung dadurch zusätzlich verschlechtert.

Es ist die der Erfindung zugrunde liegende Aufgabe, eine Betätigungshandhabe für Kraftfahrzeuge zum Öffnen und/ oder Schließen von einer Türe oder einer Klappe vorzuschlagen, welche die aus dem Stand der Technik bekannten Probleme überwindet, eine verbesserte Beleuchtung realisiert und eine Verschmutzung der Leuchtmittel verhindert.

Diese Aufgabe wird durch den Gegenstand mit den Merkmalen nach dem unabhängigen Anspruch gelöst. Vorteilhafte Ausführungsformen der Erfindung sind Gegenstand der Figuren, der Beschreibung und der abhängigen Ansprüche.

Gemäß einem Aspekt der Erfindung wird die Aufgabe durch eine Betätigungshandhabe für ein Kraftfahrzeug zum Öffnen und/ oder Schließen von einer Türe oder einer Klappe mit einem Griffelement gelöst, welches zwischen einer Betätigungsposition, in welcher das Griffelement zum manuellen Öffnen einer Türe oder einer Klappe betätigbar angeordnet ist, und einer Verriegelungsposition, in welcher das Griffelement in einer Mulde aufgenommen ist, bewegbar ausgebildet ist, wobei das Griffelement umgebende Griffelementbegrenzungsabschnitte und die Mulde Muldenbegrenzungsabschnitte aufweist, wobei die Betätigungshandhabe derart ausgebildet ist, dass jeder der Griffelementbegrenzungsabschnitte in der Verriegelungsposition des Griffelements einem jeweils korrespondierenden Muldenbegrenzungsabschnitt gegenüberliegend angeordnet ist, und wobei an den Griffelementbegrenzungsabschnitten zumindest bereichsweise Leuchtmittel angeordnet sind. Dadurch wird beispielsweise der technische Vorteil erreicht, dass eine Vorfeldbeleuchtung verbessert und eine Verschmutzung der Leuchtmittel verhindert wird. Durch die Überführung des Griffelements und damit auch der Leuchtmittel in die Betätigungsposition, wird eine verbesserte Beleuchtung des Vorfeldes bzw. des Bereichs vor der Türe oder der Klappe ermöglicht. Des Weiteren sind die Leuchtmittel in der Verriegelungsposition des Griffelements vor Verschmutzung geschützt, da das Griffelement und die Leuchtmittel während des Fahrbetriebs in der Mulde aufgenommen werden. Dadurch kann einer Verschmutzung vorgebeugt werden und die Qualität der Beleuchtung langfristig aufrecht erhalten bleiben.

Erfindungsgemäß ist das Leuchtmittel als kontinuierlicher Leuchtstreifen ausgebildet, wobei sich der Leuchtstreifen entlang der Griffelementbegrenzungsabschnitte in einer Umfangsrichtung des Griffelements erstreckt. Dadurch ergibt sich beispielsweise der Vorteil, dass die Beleuchtung in alle Richtungen gleichermaßen erfolgen kann.

In einer vorteilhaften Ausführungsform weist der kontinuierliche Leuchtstreifen an den Griffelementbegrenzungsabschnitten in einer Tiefenrichtung eine im Wesentlichen mittige Anordnung auf und ist in der Verriegelungsposition des Griffelements verdeckt. Dadurch ergibt sich beispielsweise der Vorteil, dass insbesondere in der Verriegelungsposition kein Licht nach Außen dringen kann. Zusätzlich wird der Leuchtstreifen vor Verschmutzung und vor mechanischen Einwirkung geschützt.

Erfindungsgemäß ist das Leuchtmittel dazu ausgebildet ist, in der Betätigungsposition des Griffelements einen geöffneten oder einen geschlossenen Zustand der Türe oder der Klappe anzuzeigen. Dadurch ergibt sich beispielsweise der Vorteil, dass es für einen Nutzer unmittelbar bei Sichtkontakt möglich ist, den Zustand der Türe oder der Klappe festzustellen ohne eine manuelle Betätigung des Griffelements vornehmen zu müssen.

In einer nicht erfindungsgemäßen Ausführungsform ist das Leuchtmittel dazu ausgebildet, in der Betätigungsposition des Griffelements einen Batterieladezustand eines Kraftfahrzeugs anzuzeigen. Dadurch ergibt sich beispielsweise der Vorteil, dass insbesondere bei batteriebetriebenen Elektrofahrzeugen unmittelbar ersichtlich ist, welchen Ladezustand das Kraftfahrzeug aufweist.

In einer vorteilhaften Ausführungsform weist das Griffelement eine Notbetätigungsmulde auf. Zusätzlich umfasst die Betätigungshandhabe einen Schließzylinder, welcher in der Verriegelungsposition durch das Griffelement verdeck ist. Dadurch ergibt sich beispielsweise der Vorteil, dass bei einem Defekt oder einer entleerten Batterie die Notbetätigungsmulde manuell bewegbar und der unter dem Griffelement angeordnete Schließzylinder zugänglich ist.

In einer vorteilhaften Ausführungsform ist das Griffelement durch Betätigung einer Fernbedienung oder eines Abstandssensors von der Verriegelungsposition in die Betätigungsposition überführbar. Alternativ oder zusätzlich ist das Griffelement durch einen Antrieb um eine Schwenkachse von der Verriegelungsposition in die Betätigungsposition überführbar. Dadurch ergibt sich beispielsweise der Vorteil, dass ein Nutzer sehr komfortablen Zugang zu der Türe oder der Klappe des Kraftfahrzeugs erhält. Das Öffnen erfolgt automatisch und selbst bei Dunkelheit wird durch das Leuchtmittel eine optimale Vorfeldbeleuchtung realisiert.

Ausführungsbeispiele der Erfindung sind in den Zeichnungen dargestellt und werden im Folgenden näher beschrieben.

Es zeigen:
- Fig. 1: eine schematische Darstellung einer Betätigungshandhabe in der Verriegelungsposition, und
- Fig. 2: eine schematische Darstellung einer Betätigungshandhabe in der Betätigungsposition.

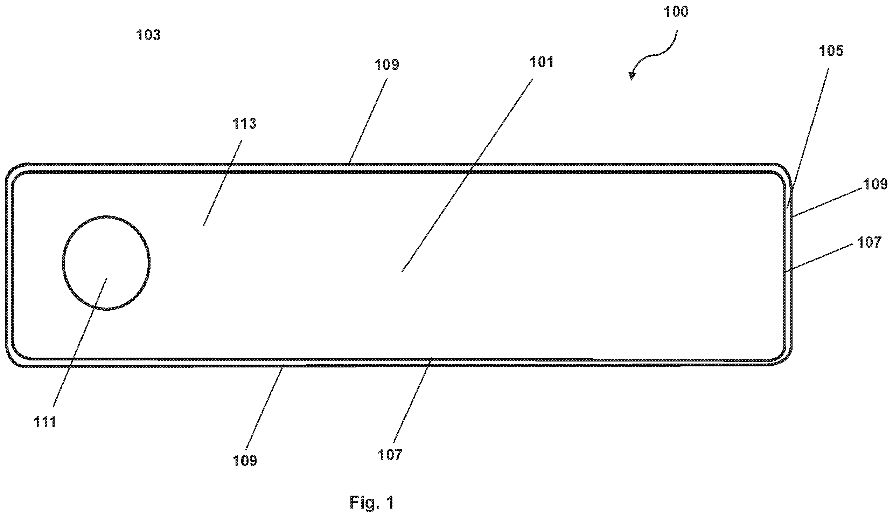

Fig. 1 zeigt eine schematische Darstellung einer Betätigungshandhabe 100 für ein Kraftfahrzeug zum Öffnen und/ oder Schließen einer Türe oder einer Klappe 103 in der Verriegelungsposition. Das Griffelement 101 hat eine rechteckige Grundform und ist in einer rechteckigen Mulde 105 aufgenommen. Das Griffelement 105 ist derart in die Mulde 105 aufgenommen, dass das Griffelement flächenbündig mit einer Türe oder einer Klappe 103 ausgebildet ist. Das Griffelement 101 ist von umgebenden Griffelementbegrenzungsabschnitten 107 begrenzt, welche im Verriegelungszustand bzw. im in die Mulde 105 aufgenommenen Zustand des Griffelements 101 korrespondierenden Muldenbegrenzungsabschnitten 109 gegenüberliegend angeordnet sind. Alternativ können das Griffelement 101 und die korrespondierende Mulde 105 eine ovale oder eine sonstige Form aufweisen. An dem Griffelement 101 ist an einer Außenfläche 113 eine Notbetätigungsmulde 111 angeordnet. Durch Drücken der Notbetätigungsmulde 111 ist es möglich, das Griffelement 101 mechanisch von der Verriegelungsposition in die Betätigungsposition zu überführen. Sie ist in der vorliegenden Ausführungsform kreisförmig ausgebildet, jedoch kann diese auch in jeder anderen denkbaren Form ausgebildet sein.

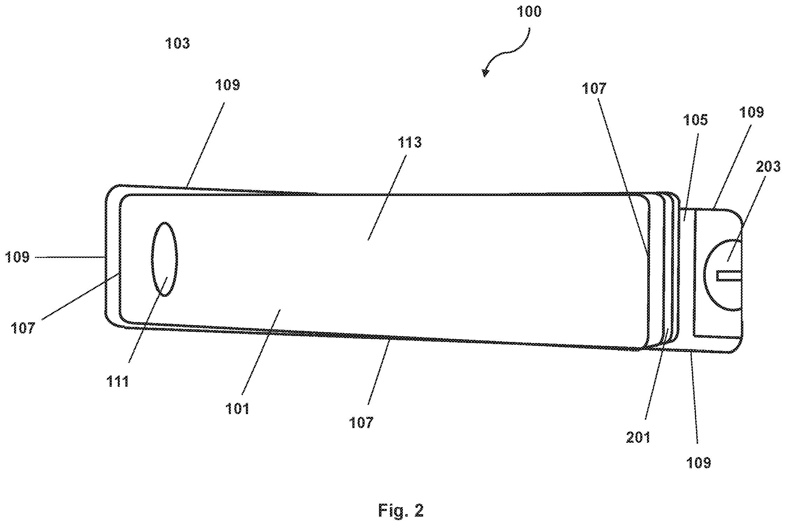

Fig. 2 zeigt eine schematische Darstellung einer Betätigungshandhabe 100 für ein Kraftfahrzeug zum Öffnen und/ oder Schließen einer Türe oder einer Klappe 103 in der Betätigungsposition. In der Betätigungsposition ist das Griffelement 101 zum manuellen Öffnen einer Türe oder einer Klappe 103 betätigbar angeordnet. In der dargestellten Ausführungsform ist das Griffelement 101 um eine Schwenkachse von der Verriegelungsposition in die Betätigungsposition überführbar ausgebildet. Dies kann beispielsweise mit einem elektrischen Antrieb realisiert werden, welcher durch Auslösen kapazitiver Sensoren an der Außenfläche 113 des Griffelements 101, durch Betätigung einer Fernbedienung oder eines Abstandssensors betätigbar ist. An den Griffelementbegrenzungsabschnitten 107 sind zumindest bereichsweise Leuchtmittel 201 angeordnet. In der vorliegenden Ausführungsform ist das Leuchtmittel 201 als kontinuierlicher Leuchtstreifen ausgebildet, wobei sich der Leuchtstreifen entlang der Griffelementbegrenzungsabschnitte 107 in einer Umfangsrichtung des Griffelements 101 erstreckt. Der kontinuierliche Leuchtstreifen kann beispielsweise durch eine Vielzahl von LEDs oder einem alternativen Leuchtmittel ausgebildet sein, wobei der kontinuierliche Leuchtstreifen an den Griffelementbegrenzungsabschnitten 107 in einer Tiefenrichtung eine im Wesentlichen mittige Anordnung aufweist. Vorzugsweise kann die mittige Anordnung des kontinuierlichen Leuchtstreifens auch in einer Tiefenrichtung versetzt angeordnet sein. Dies vereinfacht, dass das Leuchtmittel in der Verriegelungsposition besser geschützt ist und weniger Licht von dem Leuchtmittel nach Außen dringen kann. Vorzugsweise ist das Leuchtmittel 201 dazu ausgebildet, in der Betätigungsposition des Griffelements 101 einen geöffneten oder einen geschlossenen Zustand der Türe oder der Klappe 103 anzuzeigen. Beispielsweise kann dies zur Leuchten des Leuchtmittels in verschiedenen Farben realisiert werden. Denkbar wäre es hierbei einen geöffneten Zustand der Türe oder der Klappe durch grünes Leuchten des Leuchtmittels anzuzeigen, während ein geschlossener Zustand der Türe oder der Klappe durch rotes Leuchten des Leuchtmittels angezeigt werden kann. Alternativ oder zusätzlich ist das Leuchtmittel 201 dazu ausgebildet, in der Betätigungsposition des Griffelements 101 einen Batterieladezustand eines Kraftfahrzeugs anzuzeigen. Dies ist insbesondere in Anwendung eines batteriebetriebenen Kraftfahrzeugs von besonderer Bedeutung. Auf einer Außenfläche 113 weist das Griffelement 101 die Notbetätigungsmulde 111 auf. Zusätzlich weist die Betätigungshandhabe 100 einen Schließzylinder 203 auf, welcher in der Verriegelungsposition durch das Griffelement 101 verdeck ist. Durch manuelles Betätigen der Notbetätigungsmulde 111 wird der Schließzylinder 203 freigelegt und kann mit einem Schlüssel manuell betätigt werden. Alternativ oder zusätzlich wirkt die Betätigungshandhabe 100 mit einer Fernbedienung oder einem Abstandssensor zusammen. Dadurch wird die Nutzung der Betätigungshandhabe 100 für einen Nutzer sehr komfortabel, da durch Betätigung einer Fernbedienung oder durch Einwirken eines Abstandssensors das Griffelement 101 von der Verriegelungsposition in die Betätigungsposition überführt wird. Die Überführung des Griffelements 101 von der Verriegelungsposition in die Betätigungsposition erfolgt durch Schwenken durch Antrieb um eine Schwenkachse. Alternativ kann die Überführung jedoch auch translatorisch erfolgen, wobei hierbei eine geeignete Alternativlösung in Bezug auf die Notbetätigungsmulde zu finden wäre.

### BEZUGSZEICHENLISTE

- 100: Betätigungshandhabe
- 101: Griffelement
- 103: Türe oder Klappe
- 105: Mulde
- 107: Griffelementbegrenzungsabschnitt
- 109: Muldenbegrenzungsabschnitt
- 111: Notbetätigungsmulde
- 113: Außenfläche
- 201: Leuchtmittel
- 203: Schließzylinder

## Patentansprüche

1. Betätigungshandhabe (100) für ein Kraftfahrzeug zum Öffnen und/ oder Schließen von einer Türe oder einer Klappe mit einer Mulde (105) und einem Griffelement (101) welches zwischen einer Betätigungsposition, in welcher das Griffelement (101) zum manuellen Öffnen einer Türe oder einer Klappe (103) betätigbar angeordnet ist, und einer Verriegelungsposition, in welcher das Griffelement (101) in die Mulde (105) aufgenommen ist, bewegbar ausgebildet ist, wobei das Griffelement (101) umgebende Griffelementbegrenzungsabschnitte (107) und die Mulde (105) Muldenbegrenzungsabschnitte (109) aufweist, wobei die Betätigungshandhabe (100) derart ausgebildet ist, dass jeder der Griffelementbegrenzungsabschnitte (107) in der Verriegelungsposition des Griffelements (101) einem jeweils korrespondierenden Muldenbegrenzungsabschnitt (109) gegenüberliegend angeordnet ist, wobei an den Griffelementbegrenzungsabschnitten (107) zumindest bereichsweise Leuchtmittel (201) angeordnet sind ,wobei das Leuchtmittel (201) als kontinuierlicher Leuchtstreifen ausgebildet ist, wobei das Griffelement (101) derart in die Mulde 105 aufgenommen ist, dass das Griffelement flächenbündig mit der Türe oder der Klappe (103) ausgebildet ist, wobei das Griffelement (101) von den umgebenden Griffelementbegrenzungsabschnitten (107) begrenzt ist, welche im Verriegelungszustand bzw. im in die Mulde (105) aufgenommenen Zustand des Griffelements (101) korrespondierenden Muldenbegrenzungsabschnitten (109) gegenüberliegend angeordnet sind, wobei das Leuchtmittel (201) in der Verriegelungsposition des Griffelements (101) verdeckt ist,
**dadurch gekennzeichnet, dass**
sich der Leuchtstreifen entlang der Griffelementbegrenzungsabschnitte (107) in einer Umfangsrichtung des Griffelements (101) erstreckt und
das Leuchtmittel (201) dazu ausgebildet ist, in der Betätigungsposition des Griffelements (101) einen geöffneten oder einen geschlossenen Zustand der Türe oder der Klappe (103) anzuzeigen.

2. Betätigungshandhabe (100) nach Anspruch 1, **dadurch gekennzeichnet, dass** der kontinuierliche Leuchtstreifen an den Griffelementbegrenzungsabschnitten (107) in einer Tiefenrichtung eine im Wesentlichen mittige Anordnung aufweist.

3. Betätigungshandhabe (100) nach einem der vorangehenden Ansprüche, **dadurch gekennzeichnet, dass** das Griffelement (101) eine Notbetätigungsmulde (111) aufweist.

4. Betätigungshandhabe (100) nach einem der vorangehenden Ansprüche, **dadurch gekennzeichnet, dass** die Betätigungshandhabe (100) einen Schließzylinder (203) aufweist, welcher in der Verriegelungsposition durch das Griffelement (101) verdeck ist.

5. Betätigungshandhabe (100) nach einem der vorangehenden Ansprüche, **dadurch gekennzeichnet, dass** das Griffelement (101) durch Betätigung einer Fernbedienung oder eines Abstandssensors von der Verriegelungsposition in die Betätigungsposition überführbar ist.

## Claims

1. Actuating handle (100) for a motor vehicle for opening and/or closing a door or a flap with a recess (105) and a grip element (101) which is designed to be movable between an actuating position, in which the grip element (101) is arranged to be actuatable for manual opening of a door or a flap (103), and a locking position, in which the grip element (101) is accommodated in the recess (105), wherein the grip element (101) has surrounding grip element delimiting sections (107), and the recess (105) has recess delimiting sections (109), wherein the actuating handle (100) is designed such that in the locking position of the grip element (101) each of the grip element delimiting sections (107) is arranged opposite a corresponding recess delimiting section (109), wherein lighting means (201) is arranged at least in some regions on the grip element delimiting sections (107), wherein the lighting means (201) is designed as a continuous light strip, wherein the grip element (101) is accommodated in the recess (105) in such manner that the grip element is arranged flush with the door or the flap (103), wherein the grip element (101) is delimited by the surrounding grip element delimiting sections (107), which are arranged opposite the recess delimiting sections (109) when the grip element (101) is in the locking state or the state of being accommodated in the recess (105), wherein the lighting means (201) is concealed when the grip element (101) is in the locking position
**characterized in that**
the light strip extends along the grip element delimiting sections (107) in a circumferential direction of the grip element (101), and
the lighting means (201) is designed to display an open or a closed state of the door or flap (103) when the grip element (101) is in the actuating position.

2. Actuating handle (100) according to Claim 1, **characterized in that** the continuous light strip has a substantially central position in a depth direction on the grip element delimiting sections (107).

3. Actuating handle (100) according to either of the preceding claims, **characterized in that** the grip element (101) has an emergency actuation recess (111).

4. Actuating handle (100) according to any one of the preceding claims, **characterized in that** the grip element (101) has a lock cylinder (203) which is concealed by the grip element (101) in the locking position.

5. Actuating handle (100) according to any one of the preceding claims, **characterized in that** the grip element (101) can be shifted from the locking position into the actuating position by actuation of a remote control or distance sensor.

## Revendications

1. Poignée de manœuvre (100) pour un véhicule automobile destiné à ouvrir et/ou fermer une porte ou un hayon avec une cavité (105) et un élément de préhension (101), lequel est constitué mobile entre une position d'actionnement, dans laquelle l'élément de préhension (101) est disposé actionnable pour l'ouverture manuelle d'une porte ou d'un hayon (103), et une position de verrouillage, dans laquelle l'élément de préhension (101) est logé dans la cavité (105), sachant que l'élément de préhension (101) comporte des sections de délimitation d'élément de préhension entourantes (107) et la cavité (105) comporte des sections de délimitation de cavité (109), sachant que la poignée de manœuvre (100) est constituée de telle manière que chacune des sections de délimitation d'élément de préhension (107) dans la position de verrouillage de l'élément de préhension (101) est disposée opposée respectivement à une section de délimitation de cavité (109) correspondante, sachant que des moyens d'éclairage (201) sont disposés au moins par endroits sur les sections de délimitation d'élément de préhension (107), sachant que l'élément d'éclairage (201) est constitué comme bande lumineuse continue, sachant que l'élément de préhension (101) est logé dans la cavité (105) de telle manière que l'élément de préhension (101) est constitué en concordance de surface avec la porte ou le hayon (103), sachant que l'élément de préhension (101) est délimité par les sections de délimitation d'élément de préhension entourantes (107), lesquelles sont disposées à l'état de verrouillage ou à l'état logé dans la cavité (105) de l'élément de préhension (101), opposées aux sections de délimitation de cavité correspondantes (109), sachant que le moyen d'éclairage (201) est couvert dans la position de verrouillage de l'élément de préhension (101)
**caractérisée en ce que**
la bande lumineuse s'étend le long des sections de délimitation d'élément de préhension (107) dans une direction périphérique de l'élément de préhension (101) et
le moyen d'éclairage (201) est constitué à cet effet pour afficher dans la position d'actionnement de l'élément de préhension (101), un état ouvert ou un état fermé de la porte ou du hayon (103).

2. Poignée de manœuvre (100) selon la revendication 1, **caractérisée en ce que** la bande lumineuse continue comporte un système pour l'essentiel central sur les sections de délimitation de l'élément de préhension (107) dans une direction de profondeur.

3. Poignée de manœuvre (100) selon l'une quelconque des revendications précédentes, **caractérisée en ce que** l'élément de préhension (101) comporte une cavité de commande de secours (111).

4. Poignée de manœuvre (100) selon l'une quelconque des revendications précédentes, **caractérisée en ce que** la poignée de manœuvre (100) comporte un cylindre de fermeture (203), lequel est couvert dans la position de verrouillage par l'élément de préhension (101).

5. Poignée de manœuvre (100) selon l'une quelconque des revendications précédentes, **caractérisée en ce que** l'élément de préhension (101) peut être transféré de la position de verrouillage à la position de manœuvre par actionnement d'une télécommande ou d'un capteur à distance.
